(19) Europäisches Patentamt
European Patent Office
Office européen des brevets

(11)  **EP 1 683 887 A1**

(12)  **EUROPEAN PATENT APPLICATION**
published in accordance with Art. 158(3) EPC

(43) Date of publication:
**26.07.2006 Bulletin 2006/30**

(51) Int Cl.:
**C23C 14/28** (2006.01)     **H01L 21/203** (2006.01)

(21) Application number: **04771528.9**

(22) Date of filing: **11.08.2004**

(86) International application number:
**PCT/JP2004/011543**

(87) International publication number:
**WO 2005/035821 (21.04.2005 Gazette 2005/16)**

(84) Designated Contracting States:
**FI**

(30) Priority: **10.10.2003 JP 2003352948**

(71) Applicant: **Japan Science and Technology Agency**
**Kawaguchi-shi,**
**Saitama 332-0012 (JP)**

(72) Inventor: **YOSHITAKE, Tsuyoshi**
**Dazaifu-shi,**
**Fukuoka 818-0101 (JP)**

(74) Representative: **Röthinger, Rainer**
**c/o Wuesthoff & Wuesthoff**
**Patent- und Rechtsanwälte**
**Schweigerstrasse 2**
**81541 München (DE)**

(54)  **FILM DEPOSITION APPARATUS HAVING HOLE-LIKE ROTARY FILTER PLATE FOR CAPTURING FINE PARTICLES, AND FILM DEPOSITION METHOD**

(57)     [Object] In a deposition system for generating airborne fine particles containing a thin film-forming component by a laser ablation process, a sputtering process, an arc discharge process, or another process to attach the airborne fine particles to a substrate, to prevent a thin film from being contaminated using a filter for trapping droplets. The filter is shaped so as to be readily manufactured at low cost, can readily trap fine particles, and securely prevent the release of the trapped fine particles.

[Solving Means] A rotary porous filter plate includes a disk having a large number of perforations extending therethrough and is rotated on a rotary shaft connected to the center of the disk at high speed. The rotary porous filter plate is disposed between the substrate and a target such that fine particles flying through the perforations are deposited on the substrate but fine particles which fly low speed and which are transformed into droplets are trapped in the perforations. The sum of the areas of portions of the perforations is 80% or more of the surface area of the rotary porous filter plate. The perforations each have end portions and an intermediate portion having a diameter greater than those of the end portions, the end portions being located close to surface regions of the filter plate.

FIG. 2

**Description**

Technical Field

The present invention relates to deposition systems and methods for forming layers of various materials, the layers being formed in such a manner that airborne fine particles containing a thin film-forming component are generated by energy beam irradiation or arc discharge and then attached to substrates. The present invention particularly relates to a deposition system including a filter for preventing droplets from adhering to a layer to enhance the quality of the layer and also relates to a deposition method using such a filter.

Background Art

In a deposition method for forming a thin film made of metal, semiconductor, or ceramic on a substrate by a laser ablation process, a sputtering process, an arc discharge process, or another process, fine particles (liquid cluster particles deposited in a thin film) transformed into droplets need to be prevented from adhering to the substrate. Known examples of a technique for preventing this problem include a technique in which the incident angle of a laser beam applied to a target is controlled to 43 degrees or less (Patent Document 1) and techniques for rotating targets at high speed (Patent Documents 2 and 3).

In order to prevent surface properties of the thin film from being deteriorated due to the adhesion of the droplets to the substrate, a technique for trapping the flying cluster particles is used. Known examples of such a technique include a technique for attaching high-mass cluster particles to a face of a passage area-controlling member on which fine particle are incident and which have a large number of gaps (Patent Document 4), a technique using a mechanical shutter or a molecular flow shutter (Patent Document 5), deposition techniques using rotary disks which include slits and which serve as mechanical choppers for blocking high- or low-speed atoms (Patent Document 6, 7, and 8), and a technique using a deposition system including a plurality of rotary vanes (for example, Patent Document 9).

In the former one, a laser needs to be synchronized with a filter because the laser beam is pulsed; hence, the range of a selectable speed is limited. In the latter one, the vanes reflect fine particles because the vanes are tilted; hence, the vanes cannot completely trap low-speed fine particles. Since the design of vanes for trapping such low-speed fine particles is severely constrained and it is difficult to arrange a large number of such vanes in a filter, this filter needs to have a large thickness in the flight direction of the fine particles. This leads to an increase in the distance between a target and a substrate, thereby causing a problem that high-quality layers hardly formed or another problem. Furthermore, there are problems in that the manufacture of the filter requires extremely high techniques, the manufacturing cost thereof is high, and an obtained layer is contaminated with the fine particles that have been trapped and then released.

The inventor has developed a deposition system and deposition method for removing droplets using a high-speed rotary filter and has applied for a patent thereof (Patent Document 10). This filter has problems that it is difficult to completely prevent the release of such droplets and the manufacturing cost of this filter is high.

Patent Document 1: Japanese Unexamined Patent Application Publication No. 06-017237

Patent Document 2: Japanese Unexamined Patent Application Publication No. 07-166331

Patent Document 3: Japanese Unexamined Patent Application Publication No. 2001-107225

Patent Document 4: Japanese Unexamined Patent Application Publication No. 08-176805

Patent Document 5: Japanese Unexamined Patent Application Publication No. 04-202762

Patent Document 6: Japanese Unexamined Patent Application Publication No. 10-030168

Patent Document 7: Japanese Unexamined Patent Application Publication No. 2001-192811

Patent Document 8: Japanese Unexamined Patent Application Publication No. 2003-277919

Patent Document 9: Japanese Unexamined Patent Application Publication No. 10-030169

Patent Document 10: Japanese Unexamined Patent Application Publication No. 2003-049262

Disclosure of Invention

Problems to be Solved by the Invention

It is an object of the present invention to provide a deposition system and method for forming layers of various materials using a filter, the layers being formed in such a manner that airborne fine particles containing a thin film-forming component are generated in a vacuum vessel and then attached to substrates. The filter is shaped so as to be readily manufactured at low cost, can trap droplets, and can securely prevent the release of trapped fine particles although flat panel filters cannot prevent the release thereof in principle.

Means for Solving the Problems

In order to solve the above problems, a rotary porous filter plate, which is different from a known panel filter, according to the present invention has a configuration in which a disk has a large number of perforations.

The present invention provides a deposition system for generating airborne fine particles containing a thin film-forming component to attach the airborne fine particles to a substrate. The deposition system includes the rotary porous filter plate, including a disk having a large number of perforations extending therethrough, rotated on a rotary shaft connected to the center of the disk at high speed. The rotary porous filter plate is disposed between the substrate and a target such that the fine particles flying through the perforations are deposited on the substrate but the fine particles which fly low speed and which are transformed into droplets are trapped in the perforations. The present invention also provides a deposition method using the deposition system.

In the system of the present invention, the perforations each have end portions and an intermediate portion having a diameter greater than those of the end portions, the end portions being located close to surface regions of the rotary porous filter plate. Therefore, the trapped fine particles can be confined in the perforations such that the trapped fine particles can be securely prevented from being released, because the fine particles trapped in the perforations are gathered at center regions of the perforations by the rotation of the rotary porous filter plate. According to the system of the present invention, the fine particles flying in the perforations at a speed greater than or equal to a predetermined speed and the fine particles flying at a speed less than or equal to a predetermined speed can be both trapped.

Advantages

According to the present invention, a filter can be manufactured in such a manner that a large number of perforations are formed in a disk only by chemical or mechanical processing. The filter, as well as a known panel filter, can trap fine particles although the filter has a simple configuration. The trapped fine particles can be confined in center regions of the perforations by the rotation of the rotary porous filter plate because the walls of the perforations are curved; hence, deposition can be performed without releasing the trapped fine particles.

For layers formed using flat panel filters, fine particles released from the filters are observed on the layers. In contrast, for a layer formed using the rotary porous filter plate of the present invention, no fine particles released from the filter are observed on the layer; hence, the layer has high quality. The rotary porous filter plate can be more precisely manufactured at lower cost as compared to the flat panel filters.

Best Mode for Carrying Out the Invention

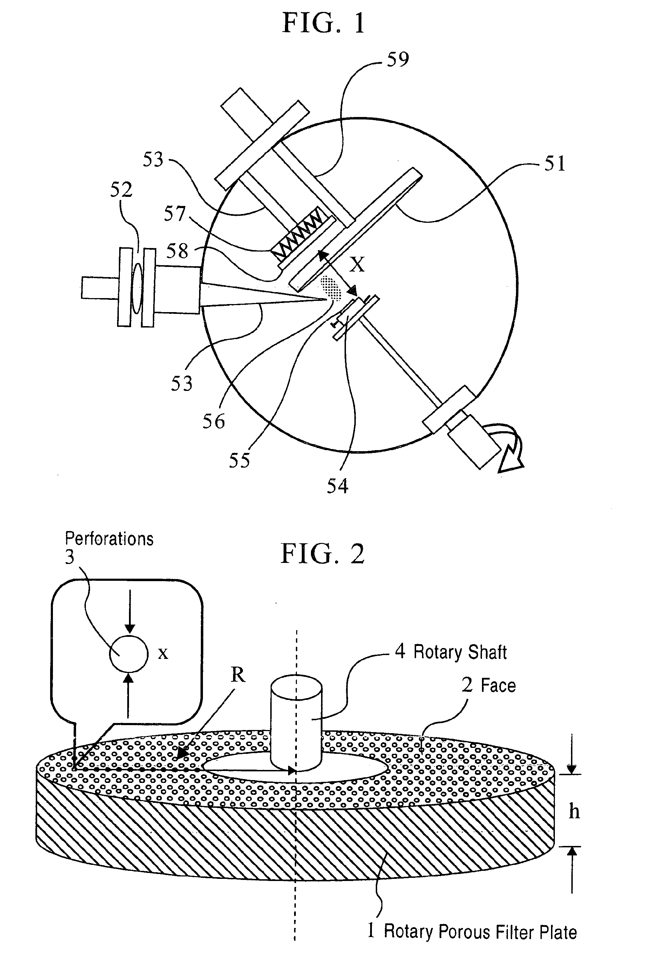

Fig. 1 is a schematic view of an example of a laser ablation deposition system including a known rotary filter. With reference to Fig. 1, a laser beam 53 focused by a lens 52 is applied to a target 55 mounted on a rotatable target holder 54 disposed in a vacuum vessel, whereby airborne fine particles 56 are generated from the target 55 and then attached to a substrate 58 mounted on a substrate holder 57. The distance between the substrate 58 and the target 58 is preferably about 10 to 100 mm. The target 55 is irradiated with the laser beam 53, whereby the airborne fine particles 56 containing a thin film-forming component are generated and allowed to fly toward the substrate 58. A rotary panel 51 for trapping the fine particles that fly at low speed and that are transformed into droplets is disposed between the target 55 and the substrate 58 and supported by a rotary shaft 59. The rotary panel 51 is rotated at high speed such that the low-speed fine particles are trapped by a portion of the rotary panel 51 that blocks the flight of the fine particles. In a method according to the present invention, a rotary porous filter plate is used instead of the known rotary filter.

Fig. 2 is a schematic perspective view showing an exemplary configuration of the rotary porous filter plate included in a system according to the present invention. A large number of perforations 3 are arranged such that the center lines thereof extend vertically between both faces of the rotary porous filter plate 1 in parallel to the flight direction of the fine particles. In Fig. 2, the following faces are parallel to each other: a face of the target which is not shown (located below the figure), a face of the substrate which is not shown (located above the figure), and both faces of the rotary porous filter plate 1. The center lines of the perforations 3 extend in parallel to a rotary shaft connected to the rotary porous filter plate 1. When the rotary porous filter plate 1 is not rotated, the fine particles flying from the target toward the substrate pass through the perforations 3 to deposit on the substrate.

The fine particles colliding with a face of the rotary porous filter plate 1 that faces the target adhere thereto. This reduces the deposition rate of the fine particles on the substrate; hence, the sum of the areas of portions of the perforations 3 is preferably large. When a face of the rotary porous filter plate 1 is viewed, the percentage of the sum of the areas of portions of the perforations 3 in the surface area of the rotary porous filter plate 1 defines the deposition rate of a layer to be formed. The reduction in deposition rate due to the use of the rotary porous filter plate can be estimated from the deposition rate determined without using the rotary porous filter plate and controlled using an equation below. Portions of the perforations 3 that are located at faces of the rotary porous filter plate 1 are supposed to have the same diameter.

$$\text{(Deposition rate)} = \text{(Deposition rate determined without}$$

$$\text{using filter plate)} \times \text{(Sum of areas of portions of}$$

$$\text{perforations / Surface area of filter plate)}$$

When the deposition rate determined without using the filter plate is, for example, 100 nm/min and the percentage of the sum of the areas of the portions of the perforations in the surface area of the filter plate is 50% or 90%, the deposition rate calculated is 50 or 90 nm/min, respectively. In order to form a layer, the percentage is preferably large. Furthermore, in order to reduce the weight of the filter plate, the percentage is preferably large. Therefore, for both faces of the rotary porous filter plate 1, the term (Sum of areas of portions of perforations / Surface area of filter plate) is preferably 80% or more and more preferably 90%. In consideration of technical constraints on perforating and in consideration of the mechanical strength of the filter plate, the upper limit thereof is about 95%.

When the sum of the areas of the portions of the perforations is large, the fine particles flying at high speed pass through the perforations but the fine particles flying at low speed are trapped in the perforations while the filter plate is being rotated at a constant speed. A small number of cluster particles adhere to regions of a face of the rotary plate on which the fine particles are incident, the regions being outside the perforations. The following speed, length, and size need to be determined such that the fine particles which fly at low speed and which are therefore transformed into droplets can be securely trapped: the rotation speed of the filter plate, the length of the perforations extending through the filter plate, the maximum size obtained by measuring each perforation in the circumferential direction of the filter plate (if the perforation is circular in cross section, the maximum size is equal to the diameter of the perforation).

When portions of the perforations 3 that are exposed at a face 2 of the rotary porous filter plate 1 have a circular shape As shown in Fig. 2, the maximum speed $V_{max}$ (in mm/second) of the fine particles that can be trapped by the rotary porous filter plate 1 is given by the equation $V_{max} = (1/2) h\omega / \tan^{-1}(X/2R)$, wherein X represents the diameter thereof, R represents the distance between the center line of the rotary shaft 4 connected to the rotary porous filter plate 1 and the center line of one of the perforations 3, h represents the length (in mm) of the perforations extending through the rotary porous filter plate 1 in the flight direction of the fine particles, and $\omega$ represents the angular speed (in radians/second) of the rotation of the rotary porous filter plate 1. The fine particles flying at a speed exceeding the maximum speed $V_{max}$ pass through the perforations to deposit on the substrate but the fine particles flying at a speed less than or equal to the maximum speed $V_{max}$ are trapped in the perforations of the rotary porous filter plate 1.

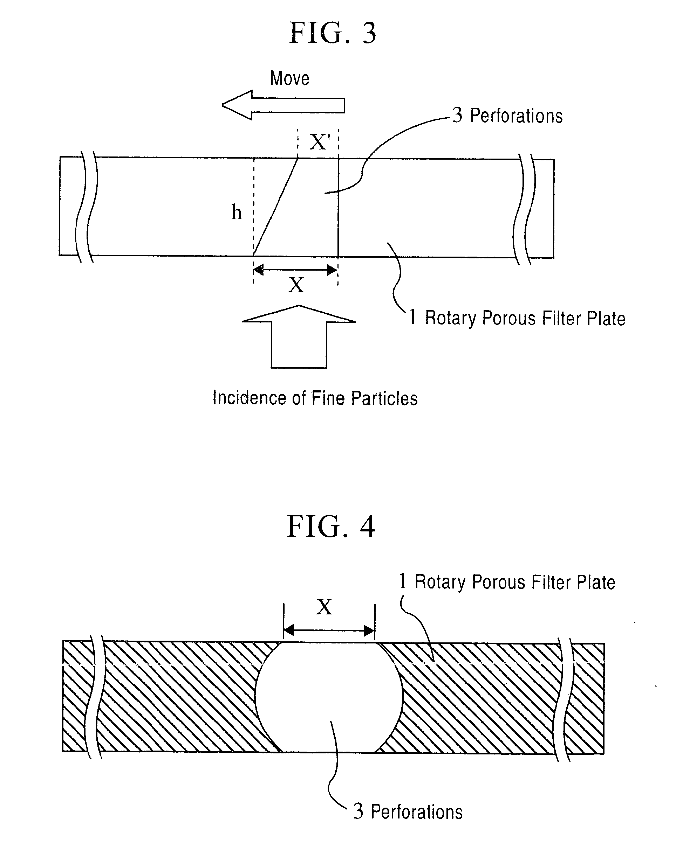

When the exit of each perforation has a diameter less than that of the entrance thereof as shown in Fig. 3, fine particles flying at a speed less than or equal to the speed given by the formula $(1/2)h\omega / \tan^{-1}(X/2R)$ are trapped, wherein X represents the diameter of the entrance thereof. Furthermore, if the inequality X - 2X' > 0 holds, the fine particles flying at a speed greater than or equal to the speed given by the formula $(1/2)h\omega / \tan^{-1}(X - X'/2R)$ are trapped, wherein X' represents the diameter of the exit thereof.

In order to cause the maximum speed of the fine particles trapped in the perforations close to the rotary shaft to agree with the maximum speed of the fine particles trapped in the perforations close to the edge of the rotary porous filter plate 1, the perforations close to the rotary shaft need to have diameters less than that of the perforations close to the edge thereof. That is, the more close to the edge of the rotary porous filter plate the perforations are, the larger diameters the perforations have. Trapping properties of the rotary porous filter plate 1 can be flexibly varied in such a manner that the diameter X and shape of the perforations 3 are varied depending on the positions on the rotary porous filter plate 1.

Fig. 4 shows a rotary porous filter plate in cross section in the thickness direction thereof. One of perforations extending through the rotary porous filter plate is shown in this figure. This perforation 3 is designed such that the diameter X of an intermediate portion of this perforation 3 is greater than those of end portions thereof. Therefore, the wall of this perforation is curved. Trapped fine particles are gathered in a wide center region of this perforation 3 and thus are prevented from being released.

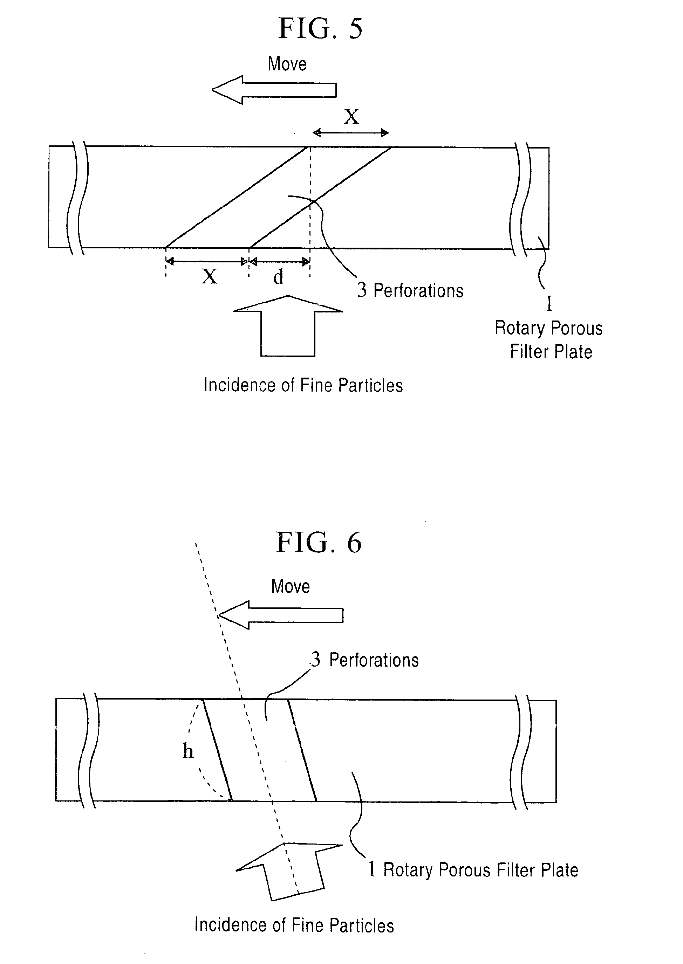

Fig. 5 shows a rotary porous filter plate 1 in cross section in the circumferential direction of this rotary porous filter plate 1. One of perforations extending through this rotary porous filter plate 1 is shown in this figure. The center line of this perforation 3 is tilted in the circumferential direction of this rotary porous filter plate 1, that is, the rotation direction thereof. The center line of this perforation 3 may extend straight in the circumferential direction. Alternatively, the center line of this perforation 3 may be curved along the circumference of this rotary plate, that is, this perforation 3 may be curved. If this perforation, as well as that perforation extending straight through that rotary porous filter plate vertically, has end portions and an intermediate portion having a diameter X greater than those of the end portions, trapped fine particles are gathered in a wide center region of this perforation and prevented from being released.

In Fig. 5, suppose that a target is disposed below this rotary porous filter plate 1, fine particles are incident on the lower face of this rotary porous filter plate 1, and this perforation 3 moves with the rotation of this rotary porous filter plate 1 toward the left side. This perforation 3 needs to extend diagonally from an incident face toward the upper right. The following size and deviation are as defined in this figure: the maximum size X obtained by measuring the shape of this perforation 3 in the circumferential direction of the filter plate, the shape being exposed at a face of this rotary porous filter plate that faces the target, and the deviation (the difference between the right end of a lower hole and the left end of an upper hole in the plane of projection) d of this perforation 3, extending diagonally from the fine particle-incident face in the reverse rotation direction, in the plane of projection.

Since this perforation 3 is diagonal to a rotary face of this rotary porous filter plate 1, the fine particles flying at a speed less than or equal to the minimum speed Vmin of the fine particles that can pass through those perforations and the fine particles flying at a speed greater than or equal to the maximum speed Vmax of the fine particles that can pass through those perforations can be both trapped in this perforation 3, as described by the following equations: $Vmin = (1 / 2)h\omega / \tan^{-1}((2X + d) / 2R)$ and $Vmax = (1 / 2)h\omega / \tan^{-1}(d / 2R)$, wherein h represents the length of this perforation extending in this rotary porous filter plate 1 in the flight direction of the fine particles (in mm); $\omega$ represents the angular speed of the rotation of this rotary porous filter plate 1 (in radians/second); R represents the distance between the center line of this perforation 3 and the center line of a rotary shaft connected to a face of this rotary porous filter plate 1 that faces the target; X represents the maximum size obtained by measuring the shape of this perforation 3 in the circumferential direction of the filter plate, the shape being exposed at the rotary porous filter plate face facing the target; and d represents the deviation of this perforation 3, extending diagonally from the fine particle-incident face in the reverse rotation direction, in the plane of projection.

Since this perforation is diagonal to the rotary face of this rotary porous filter plate, this rotary porous filter plate serves as a band-pass filter that can trap both the fine particles flying at a speed greater than or equal to the maximum speed of the fine particles that can pass through those perforations and the fine particles flying at a speed less than or equal to the minimum speed of the fine particles that can pass through those perforations, the maximum speed and minimum speed being set for each perforation. If the deviation is adjusted in such a manner that a portion of this perforation that exposed at a face of this rotary porous filter plate 1 on which the fine particles incident and a portion of this perforation that exposed at a face of this rotary porous filter plate 1 from which the fine particles are released are formed so as to have different diameters, the maximum speed of the fine particles that can pass through this perforation can be varied.

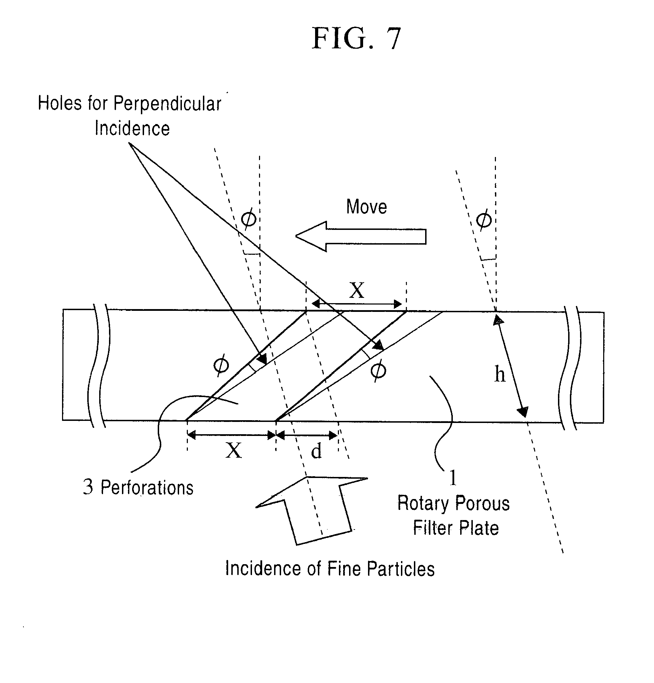

As described above, the fine particles are incident on the rotary faces of the rotary porous filter plates perpendicularly to the rotary faces. However, if a face of a target is not parallel to a face of a substrate but is diagonal to the substrate face, the center line of each perforation may be diagonal to a rotary shaft connected to a rotary porous filter plate. Fig. 6 shows an example in which the direction of the center line of the perforation shown in Fig. 2 is tilted such that the incident direction of fine particles is tilted. Fig. 7 shows an example in which the direction of the center line of the diagonal perforation shown in Fig. 5 is tilted so as to correspond to the incident direction of fine particles. If fine particles are incident on a filter plate at an angle represented by $\phi$ in the rotation direction of this filter plate, the tilt angle of this perforation 3 needs to be varied as shown in Fig. 7.

In the above description, the perforations are circular in cross section and the size of each perforation is expressed as a diameter. The perforations may have any shape, such as an elliptic shape or a polygonal shape, in cross section. Therefore, if the perforations are not circular in cross section, the maximum size obtained by measuring the cross-sectional shape of each perforation in the circumferential direction of a filter plate corresponds to the diameter of a perforation having a circular shape in cross section.

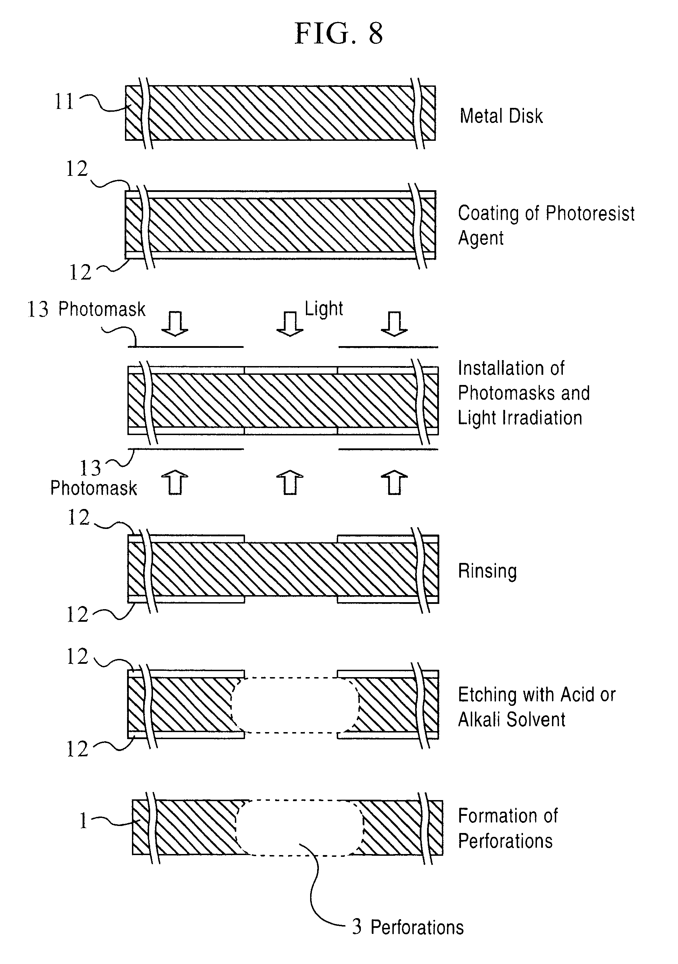

A method for manufacturing a rotary porous filter plate will now be described with reference to drawings. Fig. 8 illustrates a procedure for forming perforations in a metal disk by a photoresist process. One of the perforations is shown in this figure. A large number of the perforations 3 are precisely formed in the disk by a photolithographic process such that the perforations 3 are located at desired positions and have desired diameters. In view of the reduction in the load on a rotary system, the rotary porous filter plate is preferably made of a low-density material such as titanium. Alternatively, the rotary porous filter plate may be made of a metal material, such as stainless steel or aluminum alloy, releasing a small amount of gas in a vacuum.

Both faces of the metal disk 11 are coated with a photoresist agent 12. After the photoresist agent 12 is dried, photomasks 13 are arranged such that the perforations are formed at desired positions and have desired diameters. Light irradiation is then performed. After the resulting metal disk 11 is rinsed, the metal disk 11 is etched with an acidic or alkaline etching solution, whereby exposed portions are removed. Etching is performed such that the walls of the perforations are gouged. In the etching operation, the perforations 3 are formed such that the perforations 3 extend through the metal disk 11 and each have end portions and an intermediate portion having a diameter greater than those of the end portions. Finally, the photoresist agent 12 is removed. This provides the porous filter plate 1, in which the perforations 3 extend through the metal disk 11.

When the metal disk is made of stainless steel, the etching solution is usually a 38-42 Be ferric chloride solution; a mixture of a ferric chloride solution and nitric acid; or a mixture of 100 parts of hydrochloric acid, 6.5 parts of mercuric nitrate, and 100 parts of water. When the metal disk is made of titanium, the etching solution is usually a mixture of one part by volume of 40% hydrofluoric acid and nine parts by volume of water (30-32°C) or a mixture of a persulfate and a fluoride.

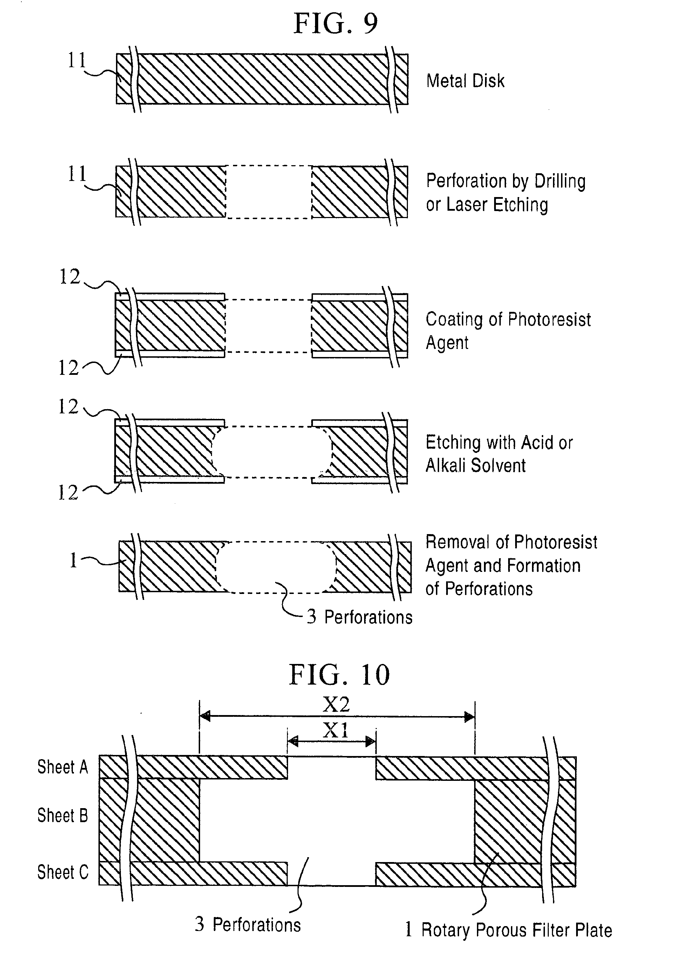

Fig. 9 illustrates another procedure for forming perforations in a metal disk 11 by drilling or laser etching. One of these perforations is shown in this figure. These perforations are formed in this metal disk 11 made of titanium or stainless steel using a drill, a high-power laser beam, or a blanking machine such that these perforations are located at desired positions and have desired diameters. The front and rear faces of this metal disk 11 are coated with an acidic or alkaline photoresist agent 12 and this metal disk 11 is immersed in an acid or alkali solution, whereby the walls of these perforations are etched. This allows these perforations 3 to each have end portions and an intermediate portion having a diameter greater than those of the end portions. After etching is finished, this photoresist agent 12 is removed. This provides this porous filter plate 1, in which these perforations 3 extend through this metal disk 11.

Fig. 10 shows an example having a perforation structure made by laminating three sheets. A rotary porous filter plate 1 is prepared by laminating a plurality of sheets A, B, and C. Holes can be formed in these sheets by photolithography, laser etching, drilling, blanking, or the like. The sheets A and C have holes having the same diameter and the holes of the sheet A are aligned with those of the sheet C. The sheet B has holes having a diameter greater than that of the holes of the sheets A and C and is sandwiched between the sheets A and C. The diameter X2 of the holes of the sheet located at an inner region of the filter plate is greater than the diameter X1 of the holes of the sheets located at outer regions thereof, that is, each perforation 3 has end portions and an intermediate portion having a diameter greater than those of the end portions.

Example 1

The following example will now be described in detail: an example in which fine particles transformed into droplets in a system, similar to that shown in Fig. 1, for a laser ablation process are trapped.

Airborne fine particles were generated in such a manner that an ArF excimer laser beam (a wavelength of 193 nm, FWHM = 20 ns) was applied to a Si target, disposed in a vacuum vessel evacuated to less than or equal to $5 \times 10^{-7}$ Torr with a turbomolecular pump, at an incident angle of 45 degrees, whereby a Si layer was deposited on a glass substrate spaced from the Si target at a distance of 50 mm. A rotary porous filter plate, similar to that shown in Fig. 2, rotatable at high speed, was placed between the target and the substrate such that some of the fine particles were trapped with the rotary porous filter plate.

The rotary porous filter plate was connected to a rotary shaft parallel to the flight direction of the fine particles fly. In order to agree with the maximum speed of the fine particles trapped in perforations arranged close to the center of the rotary porous filter plate with the maximum speed of the fine particles trapped in perforations arranged far from the center thereof, the perforations had such sizes that diameter portions of the perforations that extended in the circumferential direction made an internal angle of 3.6 degrees with the rotary shaft. That is, X and R shown in Fig. 2 were designed such that the equation $2\tan^{-1}(X/2R) = 180$, i.e., the equation $X = 2.00R \times 10^{-2}$ (in mm) held.

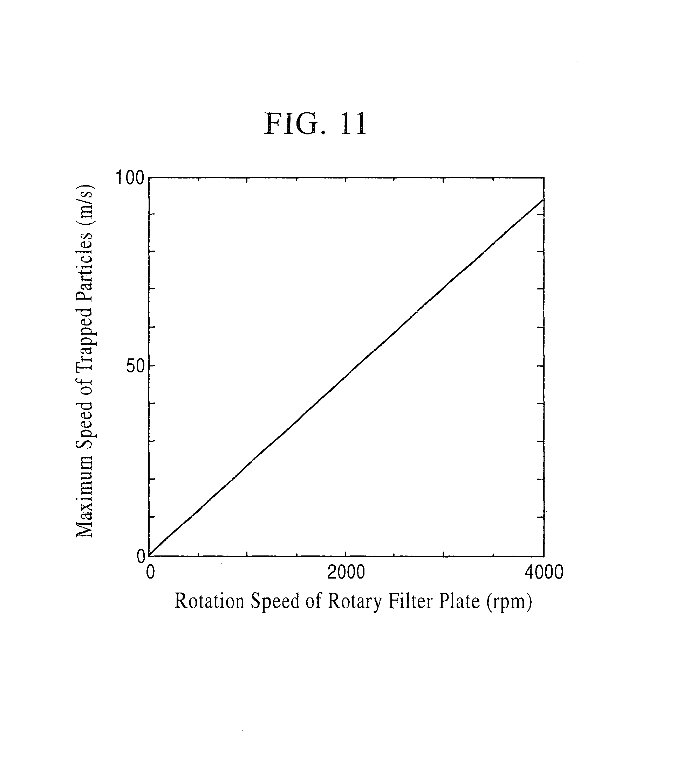

The following diameter and distance were designed such that the equation $X = 2.00R \times 10^{-2}$ (in mm) held: the diameter (the rotation direction, i.e., the circumferential direction) X of each perforation located on the side on which the fine particles were incident and the distance R between the center line of the perforation and the center line of the rotary shaft. The rotary porous filter plate was prepared using a titanium disk having a diameter of 200 mm and a thickness h of 10 mm. The perforation had end portions and an intermediate portion having a diameter about 40% greater than those of the end portions. Fig. 11 shows the relationship between the rotation speed of the rotary porous filter plate and the maximum speed of the fine particles that can be trapped with the rotary porous filter plate. The following percentage was about 90%: the percentage of the sum of the areas of portions of the perforations in the surface area of the rotary porous filter plate. The fluence F of laser pulses was 4 J/cm$^2$, the repetition frequency was 10 Hz, and the substrate was maintained at room temperature.

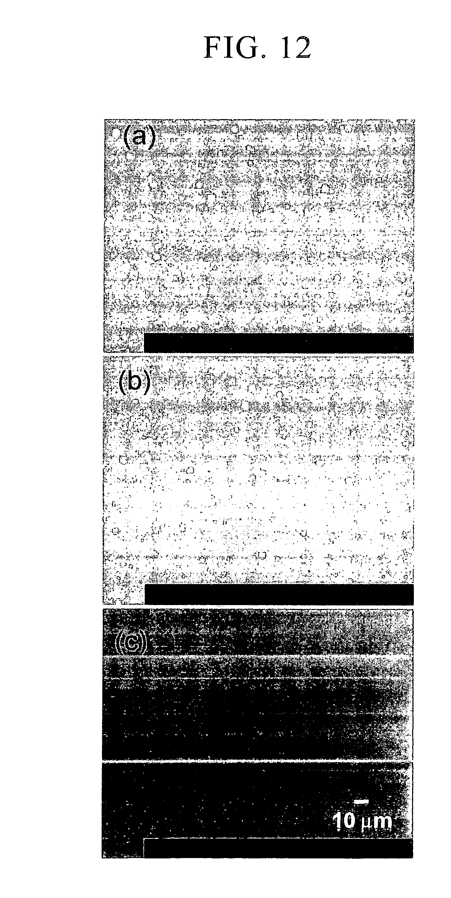

The fine particles attached to silicon layers prepared as described above were observed with a scanning electron microscope (SEM). Figs. 12(a), 12(b), and 12(c) are images of the silicon layers prepared by rotating the rotary porous filter plate at a speed of 1,000, 2,500, and 3,000 rpm, respectively. This shows that the fine particles are completely trapped with the rotary porous filter plate rotated at a speed of 3,000 rpm.

Industrial Applicability

An system and method according to the present invention are useful in depositing a thin film made of metal, semiconductor, ceramic, or the like on a substrate by a laser ablation process, a sputtering process, an arc discharge process and also useful in manufacturing a filter for trapping fine particles at low cost. Furthermore, the system and the method are useful in manufacturing a high-quality thin-film to which no droplets adhere and which is prevented from being contaminated with droplets that are trapped and then released.

Brief Description of the Drawings

[Fig. 1] Fig. 1 is a schematic view of an exemplary configuration of a laser ablation thin-film preparation system including a rotary filter.

[Fig. 2] Fig. 2 is a schematic perspective view of a rotary porous filter plate included in a system according to the present invention.

[Fig. 3] Fig. 3 is a sectional view of a rotary porous filter plate, showing the relationship between the diameter of a perforation and the speed of fine particles.

[Fig. 4] Fig. 4 is a sectional view of the rotary porous filter plate, showing the shape of a perforation in the depth direction of the perforation.

[Fig. 5] Fig. 5 is a sectional view of a rotary porous filter plate having a diagonal perforation.

[Fig. 6] Fig. 6 is a sectional view showing an example in which the direction of the center line of a perforation shown in Fig. 2 is tilted such that the incident direction of fine particles is tilted.

[Fig. 7] Fig. 7 is a sectional view showing an example in which the direction of the center line of the diagonal perforation shown in Fig. 5 is tilted so as to correspond to the incident direction of fine particles.

[Fig. 8] Fig. 8 is an illustration showing a procedure for manufacturing a rotary porous filter plate obtained by processing a metal disk by a photoresist process.

[Fig. 9] Fig. 9 is an illustration showing a procedure for manufacturing a rotary porous filter plate by drilling or laser etching.

[Fig. 10] Fig. 10 is an illustration showing a procedure for manufacturing a rotary porous filter plate by laminating three sheets.

[Fig. 11] Fig. 11 is a graph showing the relationship between the rotation speed of a rotary porous filter plate used in Example 1 and the maximum speed of fine particles that can be trapped with the rotary porous filter plate. [Fig. 12] Fig. 12 includes photographs, used instead of drawings showing SEM images of silicon layers prepared in Example 1 using a silicon target: Figs. 12(a), 12(b), and 12(c) are images of the silicon layers prepared by rotating this rotary porous filter plate at a speed of 1,000, 2,500, and 3,000 rpm, respectively.

**Claims**

**1.** A deposition system for generating airborne fine particles containing a thin film-forming component to attach the airborne fine particles to a substrate, comprising a rotary porous filter plate, including a disk having a large number of perforations extending therethrough, rotated on a rotary shaft connected to the center of the disk at high speed, wherein the rotary porous filter plate is disposed between the substrate and a target such that the fine particles flying through the perforations are deposited on the substrate but the fine particles which fly low speed and which are transformed into droplets are trapped in the perforations.

**2.** The deposition system according to Claim 1, wherein the sum of the areas of portions of the perforations is 80% or more of the surface area of the rotary porous filter plate, the portions thereof being located at faces of the rotary porous filter plate.

**3.** The deposition system according to Claim 1, wherein the perforations each have end portions and an intermediate portion having a diameter greater than those of the end portions, the end portions being located close to surface regions of the rotary porous filter plate.

4. The deposition system according to Claim 1, wherein portions of the perforations that are located at a face of the rotary porous filter plate on which the fine particles are incident has a diameter greater than that of portions thereof that are located at a face of the rotary porous filter plate from which the fine particles are released.

5. The deposition system according to Claim 1, wherein the perforations close to the edge of the filter plate have diameters greater than those of the perforations far from the edge thereof such that the fine particles flying at low speed can be uniformly trapped over a face of the rotary porous filter.

6. The deposition system according to Claim 1, wherein the center lines of the perforations are parallel to the rotary shaft of the rotary porous filter plate.

7. The deposition system according to Claim 6, wherein portions of each perforation that are located at faces of the rotary porous filter plate are circular and the maximum speed (in mm/second) of the fine particles that can be trapped by the rotary porous filter plate is given by the equation $V_{max} = (1/2)h\omega / \tan^{-1}(X/2R)$, wherein $V_{max}$ represents the maximum speed thereof, X represents the diameter of the portions thereof, R represents the distance between the center line of the rotary shaft of the rotary porous filter plate and the center line of the perforation, h represents the length (in mm) of the perforation extending in the rotary porous filter plate in the flight direction of the fine particles, and $\omega$ represents the angular speed (in radians/second) of the rotation of the rotary porous filter plate.

8. The deposition system according to Claim 1, wherein the center lines of the perforations are diagonal to the rotary shaft of the rotary porous filter plate.

9. The deposition system according to Claim 8, wherein the minimum speed and maximum speed of the fine particles that can pass through the perforations are given by the equations $V_{min} = (1/2)h\omega / \tan^{-1}((2X+d)/2R)$ and $V_{max} = (1/2)h\omega / \tan^{-1}(d/2R)$, respectively, wherein $V_{min}$ represents the minimum speed thereof, $V_{max}$ represents the maximum speed thereof, h represents the length (in mm) of each perforation extending in the rotary porous filter plate in the flight direction of the fine particles; $\omega$ represents the angular speed (in radians/second) of the rotation of the rotary porous filter plate; R represents the distance between the center line of the perforation and the center line of the rotary shaft connected to a face of the rotary porous filter plate that faces the target; X represents the maximum size obtained by measuring the shape of the perforation in the circumferential direction of the filter plate, the shape being exposed at the rotary porous filter plate face facing the target; and d represents the deviation of the perforation, extending diagonally from a face of the rotary porous filter plate on which the fine particles are incident in the reverse rotation direction, in the plane of projection.

10. The deposition system according to Claim 1, wherein the center lines of the perforation are tilted in the circumferential direction of the rotary porous filter plate.

11. The deposition system according to Claim 1, wherein the perforations are formed in the disk made of metal by etching.

12. The deposition system according to Claim 1, wherein the perforations are formed by laminating a plurality of disks having through-holes with different diameters.

13. A deposition method using the system according to any one of Claims 1 to 12.

14. The deposition method according to Claim 13, wherein fine particle-trapping properties of regions of faces of the rotary porous filter plate are adjusted on the basis of the diameter and shape of the perforations.

15. The deposition method according to Claim 13 or 14, wherein the fine particles flying at a speed greater than the maximum speed of the fine particles that can pass through the perforations and the fine particles flying at a speed less than the minimum speed of the fine particles that can pass through the perforations can be both trapped, the maximum and minimum speeds being set for each perforation.

16. The deposition method according to any one of Claims 13 to 15, wherein a laser ablation process is used.

# FIG. 1

# FIG. 2

Perforations 3

x

R

4 Rotary Shaft

2 Face

h

1 Rotary Porous Filter Plate

# FIG. 3

Move

3 Perforations

X'

h

X

1 Rotary Porous Filter Plate

Incidence of Fine Particles

# FIG. 4

1 Rotary Porous Filter Plate

X

3 Perforations

# FIG. 5

Move

X

X

d

3 Perforations

1
Rotary Porous
Filter Plate

Incidence of Fine Particles

# FIG. 6

Move

3 Perforations

h

1 Rotary Porous Filter Plate

Incidence of Fine Particles

# FIG. 7

Holes for Perpendicular
Incidence

Move

$\phi$

$\phi$

X

$\phi$

$\phi$

h

3 Perforations

X    d

1
Rotary Porous
Filter Plate

Incidence of Fine Particles

# FIG. 8

11 — Metal Disk

12 — Coating of Photoresist Agent

12 —

13 Photomask — Light — Installation of Photomasks and Light Irradiation

13 — Photomask

12 — Rinsing

12 —

12 — Etching with Acid or Alkali Solvent

12 —

1 — Formation of Perforations

3 Perforations

# FIG. 9

11 — Metal Disk

11 — Perforation by Drilling or Laser Etching

12 — Coating of Photoresist Agent
12 —

12 — Etching with Acid or Alkali Solvent
12 —

1 — Removal of Photoresist Agent and Formation of Perforations

3 Perforations

# FIG. 10

X2

X1

Sheet A

Sheet B

Sheet C

3 Perforations        1 Rotary Porous Filter Plate

# FIG. 11

# FIG. 12

<div align="center">

**INTERNATIONAL SEARCH REPORT**

</div>

| | International application No. |
|---|---|
| | PCT/JP2004/011543 |

| A. CLASSIFICATION OF SUBJECT MATTER |
|---|
| Int.Cl$^7$  C23C14/28, H01L21/203 |
| |
| According to International Patent Classification (IPC) or to both national classification and IPC |

| B. FIELDS SEARCHED |
|---|
| Minimum documentation searched (classification system followed by classification symbols) |
| Int.Cl$^7$  C23C14/28, H01L21/203 |
| |
| Documentation searched other than minimum documentation to the extent that such documents are included in the fields searched |
| Jitsuyo Shinan Koho          1922–1996   Jitsuyo Shinan Toroku Koho   1996–2004<br>Kokai Jitsuyo Shinan Koho    1971–2004   Toroku Jitsuyo Shinan Koho   1994–2004 |
| Electronic data base consulted during the international search (name of data base and, where practicable, search terms used) |
| JSTPlus FILE(JOIS) |

| C. DOCUMENTS CONSIDERED TO BE RELEVANT | | |
|---|---|---|
| Category* | Citation of document, with indication, where appropriate, of the relevant passages | Relevant to claim No. |
| A | Tsuyoshi YOSHITAKE et al., Droplet-Free Thin Films Prepared by Pulsed Laser Deposition Using a Vane Velocity Filter, Jpn.J.Appl.Phys., 2002, part 1, Vol.41, No.2A, pages 836 to 837 | 1–16 |
| A | JP 2003-49262 A  (Japan Science and Technology Corp.), 21 February, 2003 (21.02.03), Full text (Family: none) | 1–16 |
| A | JP 10-30169 A  (Mitsubishi Materials Corp.), 03 February, 1998 (03.02.98), Full text (Family: none) | 1–16 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 04 November, 2004 (04.11.04) | 22 November, 2004 (22.11.04) |
| Name and mailing address of the ISA/<br>    Japanese Patent Office | Authorized officer |
| Facsimile No. | Telephone No. |

Form PCT/ISA/210 (second sheet) (January 2004)

| | INTERNATIONAL SEARCH REPORT | International application No. |
|---|---|---|
| | | PCT/JP2004/011543 |

C (Continuation).   DOCUMENTS CONSIDERED TO BE RELEVANT

| Category* | Citation of document, with indication, where appropriate, of the relevant passages | Relevant to claim No. |
|---|---|---|
| A | E.V. PECHEN et al., Pulsed-laser deposition of smooth high-Tc supercon{}ucting films using a synchronous velocity filter, Appl.phys.Lett., 1995, Vol.66, No.17, pages 2292 to 2294 | 1-16 |
| A | JP 2003-277919 A  (Toyota Central Research And Development Laboratories, Inc.), 02 October, 2003 (02.10.03), Full text (Family: none) | 1-16 |
| A | JP 2003-73812 A  (Masaki YAMAMOTO), 12 March, 2003 (12.03.03), Full text (Family: none) | 1-16 |

Form PCT/ISA/210 (continuation of second sheet) (January 2004)